# EUROPÄISCHE PATENTANMELDUNG

(11) **EP 2 143 819 A1**
(43) Veröffentlichungstag der Anmeldung: **13.01.2010**
(21) Anmeldenummer: 08012574.3
(22) Anmeldetag: 11.07.2008
(51) Int. Cl.: C23C 16/40, C23C 16/34

(54) **Beschichtungsverfahren und Korrosionsschutzbeschichtung für Turbinen-Komponenten**

(71) Anmelder: Siemens Aktiengesellschaft, 80333 München (DE)
(72) Erfinder: Krusch, Claus, Dr., 45473 Mülheim an der Ruhr (DE); Stamm, Werner, Dr., 45481 Mülheim an der Ruhr (DE)

(57) **Zusammenfassung**

Es wird ein Verfahren zur Beschichtung einer Oberfläche (23) einer potentiell brennstoffführenden Komponente (3, 20) einer Turbine, insbesondere einer Gasturbine, offenbart, worin die Oberfläche (23) mittels chemischer Gasphasenabscheidung zunächst mit einer Titannitrid-Schicht (21) und anschließend mit einer α-Aluminiumoxid-Schicht (22) beschichtet wird. Zudem wird ein Turbinenbauteil (3, 20), beispielsweise ein Bauteil einer Gasturbine, beschrieben, welches einen Grundwerkstoff und eine potentiell brennstoffführende Oberfläche (23) umfasst. Die Oberfläche (23) weist eine Titannitrid umfassende Zwischenschicht (21) und eine α-Aluminiumoxid umfassende Deckschicht (22) auf.

## Beschreibung

Die vorliegende Erfindung betrifft ein Verfahren zur Beschichtung einer Oberfläche einer potentiell brennstoffführenden Komponente eines Turbinenbauteils. Sie betrifft zudem eine Korrosionsschutzbeschichtung für ein Turbinenbauteil, beispielsweise eine Gasturbinen-Komponente.

Auf dem Werkstoff 16Mo3 basierende, brennstoffführende Komponenten von Gasturbinen zeigen während des Betriebs in der Regel Korrosionsbefunde. Eine mögliche Ursache stellt die Bildung von Schwefelsäure dar, die durch das Zusammenwirken von kondensierender Luftfeuchtigkeit mit im Brennstoff vorhandenem Schwefelwasserstoff (H₂S) entsteht. Aber auch Schwefelwasserstoff (H₂S) im gasförmigen Zustand kann bei höheren Temperaturen, insbesondere bei mehr als 60°C, zur Sulfidierung führen. Der Grundwerkstoff 16Mo3 der insbesondere im Brennerbereich betroffenen Komponenten weist keine Beständigkeit gegen mineralische Säuren bzw. H₂S auf.

Die Korrosion ist insbesondere im Bereich der Innenräume eines Vormischbrenners zu beobachten, die je nach Betriebsweise entweder mit Gas oder mit Luft durchströmt werden. In den Innenräumen entstandene Korrosionspartikel, die sich von den Innenwänden lösen, können zu Verstopfungen der Gasaustrittsdüsen führen. Daraus resultieren außerplanmäßige beziehungsweise verlängerte Anlagenstillstände aufgrund von Schnellschlüssen (Trips), Schieflasten, Verbrennungsschwingungen und verminderte Leistung.

Bisher wurden die Brennerkomponenten im Einzelfall aus korrosionsbeständigem Werkstoff gefertigt. Die Verwendung solcher, typischerweise Nickel-Basislegierungen ist jedoch mit einer Reihe von Nachteilen verbunden. Neben den höheren Werkstoffkosten weisen Nickel-Basislegierungen eine schlechtere Bearbeitbarkeit auf. Aus der im Vergleich zu 16Mo3 wesentlich geringeren Wärmeleitfähigkeit resultieren höhere thermisch induzierte Spannungen aufgrund von größeren Temperaturgradienten.

Es ist daher eine Aufgabe der vorliegenden Erfindung, ein Verfahren zur korrosionsmindernden Beschichtung einer Oberfläche einer potentiell brennstoffführenden Komponente einer Gasturbine zur Verfügung zu stellen. Es ist eine weitere Aufgabe, ein vorteilhaftes Turbinenbauteil, welches einen Grundwerkstoff und eine potentiell brennstoffführende Oberfläche umfasst, zur Verfügung zu stellen. Zudem ist es eine Aufgabe der vorliegenden Erfindung, eine vorteilhafte Gasturbine zur Verfügung zu stellen.

Die erste Aufgabe wird durch ein Verfahren zur Beschichtung einer Oberfläche einer potentiell brennstoffführenden Komponente eines Turbinenbauteils, insbesondere einer Gasturbine, nach Anspruch 1 gelöst. Die zweite Aufgabe wird durch ein Turbinenbauteil, welches einen Grundwerkstoff und eine potentiell brennstoffführende Oberfläche umfasst, nach Anspruch 14 gelöst. Die dritte Aufgabe wird durch eine Gasturbine nach Anspruch 15 gelöst. Die abhängigen Ansprüche umfassen weitere, vorteilhafte Ausgestaltungen der vorliegenden Erfindung. Die Merkmale sind sowohl einzeln als auch in Kombination miteinander vorteilhaft.

Im Rahmen des erfindungsgemäßen Verfahrens zur Beschichtung einer Oberfläche einer potentiell brennstoffführenden Komponente eines Turbinenbauteils wird die Oberfläche mittels chemischer Gasphasenabscheidung (CVD) zunächst mit einer Titannitrid-Schicht und anschließend mit einer α-Aluminiumoxid-Schicht beschichtet. Vorzugsweise wird eine Oberfläche, welche Stahl der Sorte 16Mo3 umfasst, beschichtet. Durch die mithilfe des erfindungsgemäßen Verfahrens erzeugte Korrosionsschutzschicht werden die Vorteile des Werkstoffes 16Mo3 bezüglich des thermischmechanischen Verhaltens, der Werkstoffkosten und der mechanischen Bearbeitbarkeit mit der Korrosionsbeständigkeit gegen Schwefelsäure oder Sulfidierung vereint.

Das erfindungsgemäße Korrosionsschutzprinzip basiert auf der physikalischen Trennung von korrosivem Medium, beispielsweise Schwefelsäure oder H₂S verunreinigtem Gas, und einem Grundwerkstoff, beispielsweise Stahl der Sorte 16Mo3. Der Schichtaufbau ist zweilagig, das heißt die Schicht besteht aus einer Zwischenschicht und einer Deckschicht. Die Bauteiloberfläche wird mittels chemischer Gasphasenabscheidung (CVD) zunächst mit einer Titannitrid(TiN)-Zwischenschicht und anschließend mit einer dichten a-Aluminiumoxid(α-Al₂O₃)-Deckschicht beschichtet. Die Titannitrid(TiN)-Zwischenschicht ist erforderlich, da im Rahmen von Laborversuchen eine direkte Haftung von α-Aluminiumoxid auf Stahl der Sorte 16Mo3 nicht erreicht werden konnte.

Im Rahmen des erfindungsgemäßen Verfahrens kann die zu beschichtende Oberfläche zunächst erhitzt werden. Die erhitzte Oberfläche kann mit Titannitrid und unmittelbar anschließend mit α-Aluminiumoxid beschichtet werden. Die so beschichtete Oberfläche kann dann wieder abgekühlt werden. Prinzipiell kann die Beschichtung mit Titannitrid und α-Aluminiumoxid in demselben Ofen durchgeführt werden. Die Oberfläche kann grundsätzlich durch Gasphasenammonolyse (4 TiCl₄ + 6 NH₃ → 4 TiN + 16 HCl + N₂ + H₂) und/oder Wasserstoff-Plasmabeschichtung (2 TiCl₄ + 4 H₂ + N₂ → 2 TiN + 8 HCl) mit Titannitrid beschichtet werden.

Die zu beschichtende Oberfläche kann also sequentiell während einer CVD-Ofenfahrt beschichtet werden. In diesem Fall ist ein CVD-Ofen erforderlich, in dem neben der α-Al₂O₃-Abscheidung die Abscheidung von TiN durch Gasphasenammonolyse (4 TiCl₄ + 6 NH₃ → 4 TiN + 16 HCl + N₂ + H₂), Wasserstoff-Plasmabeschichtung (2 TiCl₄ + 4 H₂ + N₂ → 2 TiN + 8 HCl) oder andere geeignete Verfahren durchgeführt werden kann.

Die zu beschichtende Oberfläche kann im Rahmen der chemischen Gasphasenabscheidung mit einem Temperaturanstieg zwischen 700°C/h und 900°C/h, vorzugsweise mit einem Temperaturanstieg von 800°C/h, erhitzt werden. Weiterhin kann die Oberfläche im Rahmen der chemischen Gasphasenabscheidung bei einem Druck zwischen 50mbar und 150mbar, vorzugsweise bei einem Druck von 100mbar, erhitzt und/oder abgekühlt werden.

Zudem kann die Oberfläche während des Erhitzens und/oder des Abkühlens im Rahmen der chemischen Gasphasenabscheidung mit einem Argon und Wasserstoff umfassenden Gas gespült werden. Beispielsweise kann während des Erhitzens mit einem zu 80% bis 85%, vorzugsweise zu 83%, aus Argon und zu 15% bis 20%, vorzugsweise zu 17%, aus Wasserstoff bestehendes Gas gespült werden. Während des Abkühlens kann beispielsweise mit einem zu 15% bis 20%, vorzugsweise zu 17%, aus Argon und zu 80% bis 85%, vorzugsweise zu 83%, aus Wasserstoff bestehendes Gas gespült werden. Vorteilhafterweise wird mit einem Gasfluss von 16 bis 20 Litern pro Stunde, vorzugsweise mit 18 Litern pro Stunde, gespült werden. Diese Angaben sind jedoch von der Größe des verwendeten Ofens abhängig.

Die zu beschichtende Oberfläche kann im Rahmen der chemischen Gasphasenabscheidung mit einem Temperaturabfall von zwischen 300°C/h und 500°C/h, vorteilhafterweise mit einem Temperaturabfall von 400°C/h, abgekühlt werden.

Die Oberfläche kann weiterhin im Rahmen der chemischen Gasphasenabscheidung bei einer Temperatur zwischen 900°C und 1100°C, alternativ bei einer Temperatur zwischen 1000°C und 1100°C, vorzugsweise bei einer Temperatur von 1050°C, beschichtet werden. Es kann die Oberfläche bei einem Gasfluss von 16 bis 20 Litern pro Stunde, vorzugsweise mit 18 Litern pro Stunde, beschichtet werden. Die Oberfläche kann beispielsweise bei einem Druck zwischen 20mbar und 40bar, vorzugsweise bei einem Druck von 30mbar, mit Titannitrid beschichtet werden. Sie kann weiterhin bei einem Druck zwischen 80mbar und 120mbar, vorzugsweise bei einem Druck von 100mbar, mit α-Aluminiumoxid beschichtet werden.

Im Falle, dass die Oberfläche im Rahmen der chemischen Gasphasenabscheidung bei einem Druck von 20mbar bis 40mbar mit Titannitrid beschichtet wird, kann sich der Druck aus 0,2mbar bis 1mbar TiCl₄, 18,4mbar bis 28mbar H₂ und 2,4mbar bis 11mbar N₂ zusammensetzen. Wird die Oberfläche bei einem Druck von 30mbar mit Titannitrid beschichtet, kann sich dieser Druck beispielsweise aus 0,4mbar TiCl₄, 23,68mbar H₂ und 5,92mbar N₂ zusammensetzen.

Im Falle, dass die Oberfläche im Rahmen der chemischen Gasphasenabscheidung bei einem Druck von 80mbar bis 120mbar mit α-Aluminiumoxid beschichtet wird, kann der Druck 20mbar bis 25mbar Ar, 10mbar bis 15mbar CO₂, 20mbar bis 40mbar H₂ und 2mbar bis 6mbar HCl umfassen. Dabei kann einem AlCl₃-Generator 20mbar bis 40mbar H₂ und 2mbar bis 6mbar HCl zugeführt werden. Wird die Oberfläche beispielsweise bei einem Druck von 100mbar mit α-Aluminiumoxid beschichtet, kann dieser Druck 22,7mbar Ar, 12mbar CO₂, 30mbar H₂ und 4mbar HCl umfassen. Dabei kann einem AlCl₃-Generator 30mbar H₂ und 3,9mbar HCl zugeführt werden.

Weiterhin kann die Oberfläche im Rahmen der chemischen Gasphasenabscheidung während einer Zeitdauer zwischen zwei Stunden und vier Stunden, vorzugsweise während einer Zeitdauer von drei Stunden, mit Titannitrid beschichtet werden. Zudem kann sie während einer Zeitdauer zwischen drei Stunden und fünf Stunden, vorzugsweise während einer Zeitdauer von vier Stunden, mit α-Aluminiumoxid beschichtet werden.

Das erfindungsgemäße Verfahren hat den Vorteil, dass es auf beliebige Geometrien anwendbar ist und insbesondere auch zur Innenbeschichtung geeignet ist. Es eröffnet zudem die Möglichkeit der Beschichtung enger, innen liegender Kanäle, da ein gasförmiges Trägermedium verwendet wird. Zudem entstehen im Vergleich zu einer Nickel-Basislegierung wesentlich geringere Werkstoff- und Bearbeitungskosten von 16Mo3. Mithilfe des erfindungsgemäßen Verfahrens entstehen insgesamt geringere Beschichtungskosten.

Ein weiterer Vorteil des erfindungsgemäßen Verfahrens besteht darin, dass die erzeugte Beschichtung ein günstigeres thermisch-mechanisches Verhalten im Vergleich zu Nickel-Basislegierungen aufweist. Insbesondere entstehen infolge des geringeren Temperaturgradienten geringere thermisch induzierte Spannungen. Eine Korrosionsbeständigkeit der durch das erfindungsgemäße Verfahren erzeugten Beschichtung gegen schweflige Säure oder H₂S verunreinigtes Gas und eine Thermoschockbeständigkeit der Beschichtung konnten im Laborversuch nachgewiesen werden.

Das erfindungsgemäße Turbinenbauteil umfasst einen Grundwerkstoff und eine potentiell brennstoffführende Oberfläche. Die Oberfläche weist eine Titannitrid umfassende Zwischenschicht und eine α-Aluminiumoxid umfassende Deckschicht auf. Das heißt, die Oberfläche ist mit Titannitrid beschichtet und die Titannitrid-Beschichtung ist ihrerseits mit α-Aluminiumoxid beschichtet. Bei dem erfindungsgemäßen Turbinenbauteil kann es sich insbesondere um eine Komponente einer Gasturbine handeln. Beispielsweise kann es sich bei dem erfindungsgemäßen Turbinenbauteil um eine Komponente eines Brenners handeln.

Das erfindungsgemäße Turbinenbauteil hat den Vorteil, dass die Beschichtung korrosionsbeständig gegen schweflige Säure und thermoschockbeständig ist. Hierbei sorgt die α-Aluminiumoxidschicht für die Korrosionsbeständigkeit und die Titannitridschicht für die Anbindung der α-Aluminiumoxidschicht an den Grundwerkstoff.

Bei dem Grundwerkstoff kann es sich insbesondere um Stahl der Sorte 16Mo3 handeln. Das erfindungsgemäße Turbinenbauteil zeichnet sich in diesem Fall durch wesentlich geringere Werkstoff- und Bearbeitungskosten von 16Mo3 im Vergleich zu Nickel-Basislegierungen aus. Zudem ist infolge des geringeren Temperaturgradienten und damit der geringeren thermisch induzierten Spannungen das thermisch-mechanische Verhalten im Vergleich zu Nickel-Basislegierungen günstiger.

Die erfindungsgemäße Gasturbine umfasst ein erfindungsgemäßes Turbinenbauteil, wie es zuvor beschrieben wurde. Die erfindungsgemäße Gasturbine hat dieselben Vorteile wie das erfindungsgemäße Turbinenbauteil.

Weitere Merkmale, Eigenschaften und Vorteile der vorliegenden Erfindung werden im Folgenden anhand eines Ausführungsbeispiels unter Bezugnahme auf die beigefügten Figuren näher beschrieben. Die Ausführungsvarianten sind sowohl einzeln als auch in Kombination miteinander vorteilhaft.
- Fig. 1: zeigt schematisch das Prinzip eines CVD-Beschichtungsofens zur Abscheidung von α-Al₂O₃ und TiN.
- Fig. 2: zeigt schematisch einen Schnitt durch die erfindungsgemäße Bauteilbeschichtung.
- Fig. 3: zeigt schematisch eine Gasturbine.

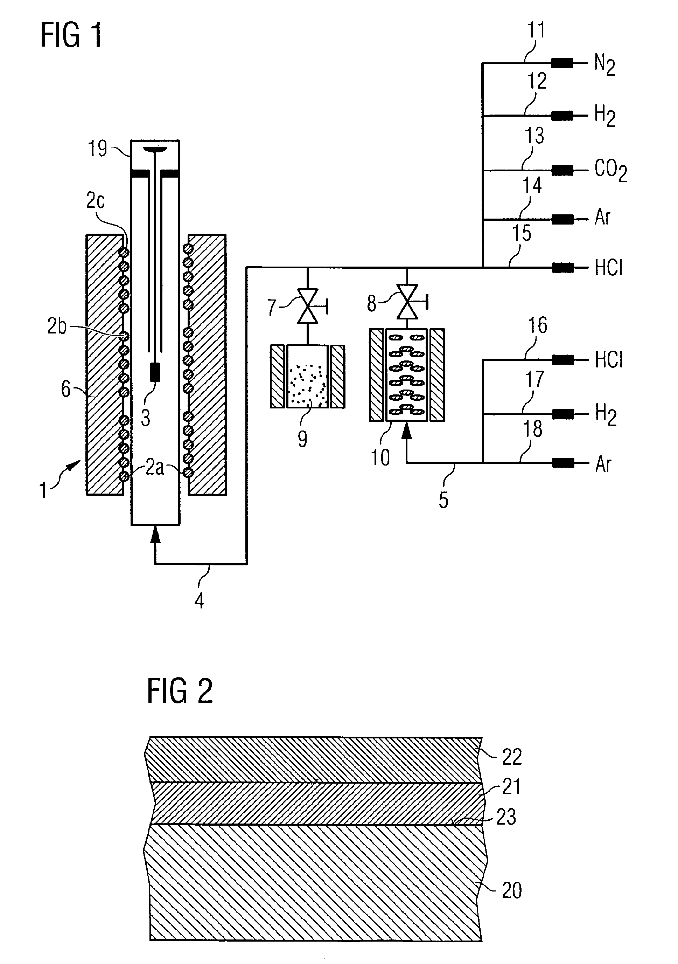

Nachfolgend wird ein Ausführungsbeispiel der vorliegenden Erfindung anhand der Figuren 1 bis 3 näher beschrieben.

Die Figur 1 zeigt schematisch einen CVD-Ofen 1 zur Beschichtung eines Gasturbinenbauteiles 3, welches beispielsweise aus Stahl der Sorte 16Mo3 besteht, mittels chemischer Gasphasenabscheidung (CVD). Der CVD-Ofen 1 umfasst ein Gehäuse 6. Innerhalb des Gehäuses 6 ist ein Innenraum 19 angeordnet, in dem das zu beschichtende Bauteil 3 platziert werden kann. An der zu dem Innenraum 19 hingewandten Seite des Gehäuses 6 sind Heizspiralen 2 angeordnet. Im vorliegenden Ausführungsbeispiel sind drei Heizspiralen 2a, 2b und 2c angeordnet, wodurch sich drei Heizzonen realisieren lassen.

Der in der Figur 1 gezeigte CVD-Ofen 1 eignet sich sowohl zur Beschichtung mit Titannitrid als auch zur Beschichtung mit α-Aluminiumoxid. Beide Beschichtungsschritte können sequentiell während einer Ofenfahrt durchgeführt werden, also ohne ein Abkühlen und wieder Erhitzen der Bauteil zwischen der Beschichtung mit Titannitrid und α-Aluminiumoxid. Die für die chemische Gasphasenabscheidung erforderlichen gasförmigen Ausgangsverbindungen werden über eine Gasleitung 4 in den Innenraum 19 des CVD-Ofens 1 geleitet. Der Innenraum 19 kann beispielsweise einen Durchmesser von 44mm aufweisen.

An die Gasleitung 4 ist über ein Ventil 7 ein TiCl₄-Verdampfer 9 angeschlossen. Zusätzlich ist über ein weiteres Ventil 8 ein AlCl₃-Generator mit Aluminium-Pellets an die Gasleitung 4 angeschlossen. Darüber hinaus können über eine Stickstoffzuleitung 11, eine Wasserstoffzuleitung 12, eine Kohlendioxidzuleitung 13, eine Argonzuleitung 14 und eine Wasserstoffchloridzuleitung 15 jeweils Stickstoff, Wasserstoff, Kohlendioxid, Argon und Wasserstoffchlorid in die Gasleitung 4 eingeleitet werden.

Weiterhin ist der AlCl₃-Generator 10 über eine Gasleitung 5 mit einer Wasserstoffchloridzuleitung 16, einer Wasserstoffzuleitung 17 und einer Argonzuleitung 18 verbunden. Durch diese Zuleitungen 16, 17 und 18 können Wasserstoffchlorid, Wasserstoff und Argon über die Gasleitung 5 in den AlCl₃-Generator eingeleitet werden.

In dem in der Figur 1 gezeigten CVD-Ofen kann neben der α-Al₂O₃-Abscheidung die Abscheidung von TiN durch Gasphasenammonolyse (4 TiCl₄ + 6 NH₃ → 4 TiN + 16 HCl + N₂ + H₂), Wasserstoff-Plasmabeschichtung (2 TiCl₄ + 4 H₂ + N₂ → 2 TiN + 8 HCl) oder andere geeignete Verfahren durchgeführt werden.

Zur Beschichtung eines Bauteils 3 mit einer Titannitrid(TiN)-Zwischenschicht wird das Bauteil 3 zunächst mit einer Heizgeschwindigkeit von 800°C/h bei einem Druck von 100mbar erhitzt. Währenddessen wird das Bauteil 3 mit einem Gas, welches zu 83% aus Argon und zu 17% aus Wasserstoff besteht, gespült. Der Gasfluss beträgt dabei beispielsweise 18 Liter pro Stunde, abhängig von der Größe des Ofens. Dabei wird das Argon über die Argonzuleitung 14 und der Wasserstoff über die Wasserstoffzuleitung 12 in die Gasleitung 4 und über diese in den Innenraum 19 des CVD-Ofens 1 eingeleitet.

Die anschließende Titannitridabscheidung erfolgt bei einer Temperatur von 1050°C und einem Druck von 30mbar. Dabei wird das Bauteil 3 mit einem Precursor-Gas bestehend aus TiCl₄, H₂ und N₂, bei einem Gasfluss von beispielsweise 18 Liter pro Stunde gespült. Das Titanchlorid (TiCl₄) wird dabei aus dem TiCl₄-Verdampfer 9 über das Ventil 7 in die Gasleitung 4 eingeleitet und gelangt von dort in den Innenraum 19 des CVD-Ofens 1. Zudem wird der Wasserstoff (H₂) über die Wasserstoffzuleitung 12 und der Stickstoff (N₂) über die Stickstoffzuleitung 11 in die Gasleitung 4 eingeleitet. Das Precursor-Gas ist dabei so zusammengesetzt, dass das TiCl₄ 0,40mbar, H₂ 23,68mbar und N₂ 5,92mbar zu dem Gesamtdruck von 30mbar beitragen. Die Abscheidung erfolgt während einer Zeit von drei Stunden.

Im Rahmen der Titannitridabscheidung sollte zur Vermeidung von Phasenübergängen die Temperatur nicht lange auf 1050°C gehalten werden. Die Temperatur kann insbesondere auch bei 950°C gehalten werden.

Im Anschluss an die Titannitridabscheidung wird das Bauteil 3 mit einer Geschwindigkeit von 400°C/h bei einem Druck von 100mbar abgekühlt. Dabei wird das Bauteil 3 bei einem Gasfluss von 18 Liter pro Stunde mit einem Gas bestehend zu 17% aus Argon und zu 83% aus Wasserstoff gespült. Das Argon wird wiederum über die Argonzuleitung 14 und der Wasserstoff über die Wasserstoffzuleitung 12 in die Gasleitung 4 und über diese in den Innenraum 19 des CVD-Ofens 1 eingeleitet.

Zur Erzeugung der α-Al₂O₃-Deckschicht wird das Bauteil 3 wiederum mit einer Heizgeschwindigkeit von 800°C/h bei einem Druck von 100mbar und einem Gasfluss von 18 Litern pro Stunde erhitzt. Das Gas, mit welchem das Bauteil 3 während des Erhitzens gespült wird, setzt sich zu 83% aus Argon und zu 17% aus Wasserstoff zusammen und wird über die Zuleitungen 4, 12 und 14 zu Bauteil 3 geleitet.

Während der anschließenden α-Aluminiumoxidabscheidung wird das Bauteil 3 bei einer Temperatur von 1050°C mit einem Gas bestehend aus Argon, Kohlendioxid, Wasserstoff und Wasserstoffchlorid gespült. Der Gasfluss beträgt dabei beispielsweise 18 Liter pro Stunde und der Druck 100mbar. Die Abscheidung erfolgt während einer Zeit von vier Stunden. Während der Beschichtung wird dem AlCl₃-Generator 10 über die Gasleitung 5 und die Wasserstoffzuleitung 17 Wasserstoff mit einem Druck von 30mbar zugeführt. Weiterhin wird dem AlCl₃-Generator 10 über die Gasleitung 5 und die Wasserstoffchloridzuleitung 16 Wasserstoffchlorid bei einem Druck von 3,9mbar zugeführt. Das mithilfe des AlCl₃-Generators 10 erzeugte Aluminiumchlorid wird über das Ventil 8 und die Gasleitung 4 in den Innenraum 19 des CVD-Ofens 1 eingeleitet. Zusätzlich wird über die Argonzuleitung 14 Argon mit einem Druck von 22,7mbar über die Gasleitung 4 in den Innenraum 19 eingeleitet. Darüber hinaus wird über die Kohlendioxidzuleitung 13 Kohlendioxid mit einem Druck von 12mbar und über die Wasserstoffzuleitung 12 Wasserstoff mit einem Druck von 30mbar in die Gasleitung 4 und über diese in den Innenraum 19 eingeleitet. Zusätzlich wird über die Wasserstoffchloridzuleitung 15 Wasserstoffchlorid mit einem Druck von 4mbar in die Gasleitung 4 und über diese in den Innenraum 19 eingeleitet.

Nach Abschluss des Abscheidungsprozesses wird das Bauteil 3 mit einer Kühlgeschwindigkeit von 400°C/h abgekühlt. Dabei wird das Bauteil 3 bei 100mbar mit einem Gas bestehend zu 12% aus Argon und zu 83% aus Wasserstoff gespült. Der Gasfluss beträgt dabei beispielsweise 18 Liter pro Stunde. Argon und Wasserstoff werden über die Zuleitungen 4, 12 und 14 zum Bauteil 3 geleitet.

Grundsätzlich können die Titannitrid-Abscheidung und die α-Aluminiumoxid-Abscheidung unmittelbar nacheinander, also während einer Ofenfahrt, erfolgen. In diesem Fall muss das Bauteil 3 zwischen diesen beiden Abscheidungsprozessen nicht abgekühlt und wieder erhitzt werden.

Die mithilfe des erfindungsgemäßen Verfahrens erzielte Beschichtung ist schematisch in der Figur 2 dargestellt. Die Figur 2 zeigt einen Schnitt durch einen Teil einer potentiell brennstoffführenden Komponente einer Gasturbine 20 als Beispiel für ein erfindungsgemäß beschichtetes Bauteil 3. Die Komponente 20 ist mit einer Titannitrid-Zwischenschicht 21 und mit einer α-Aluminiumoxid-Deckschicht 22 beschichtet. Die potentiell brennstoffführende Komponente 20 kann beispielsweise aus Stahl der Sorte 16Mo3 bestehen. Bei der Komponente 20 kann es sich insbesondere um eine Brennerkomponente handeln.

Die Oberfläche 23 der potentiell brennstoffführenden Komponente 20 wird durch die Beschichtung mit Titannitrid 21 und α-Aluminiumoxid 22 effektiv gegen Korrosionen geschützt. Darüber hinaus besteht eine sehr gute Thermoschockbeständigkeit der beschichteten Oberfläche. Thermoschocktests, bei denen das auf 420°C erhitzte, beschichtete Bauteil 3, 20 mit Wasser von 20°C abgeschreckt wurde, zeigen, dass auch nach einhundertmaliger Wiederholung des Erhitzens und Abschreckens des Bauteils das Bauteil keinerlei Risse oder Beschädigungen aufweist. Auch konnten keine Veränderungen in der Zusammensetzung des Bauteil beziehungsweise der Beschichtung beobachtet werden.

Grundsätzlich kann es sich bei dem erfindungsgemäßen Bauteil 3 bzw. der potentiell brennstoffführende Komponente 20 um eine Komponente einer Gasturbine handeln.

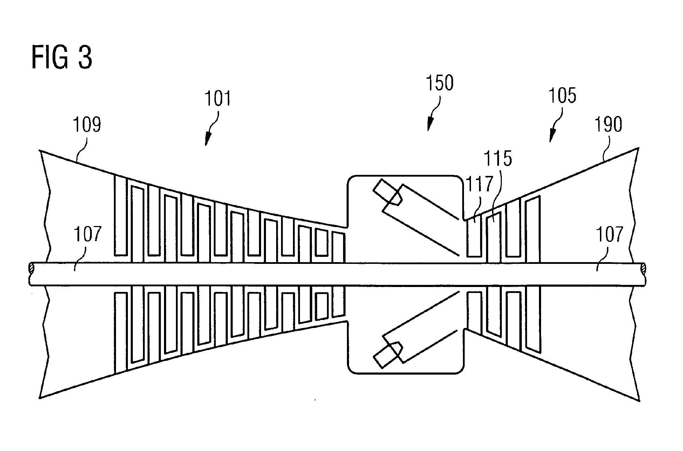

Die Figur 3 zeigt schematisch eine Gasturbine. Eine Gasturbine weist im Inneren einen um eine Rotationsachse drehgelagerten Rotor mit einer Welle 107 auf, der auch als Turbinenläufer bezeichnet wird. Entlang des Rotors folgen aufeinander ein Ansauggehäuse 109, ein Verdichter 101, eine Brenneranordnung 150, eine Turbine 105 und das Abgasgehäuse 190.

Die Brenneranordnung 150 kommuniziert mit einem beispielsweise ringförmigen Heißgaskanal. Dort bilden mehrere hintereinander geschaltete Turbinenstufen die Turbine 105. Jede Turbinenstufe ist aus Schaufelringen gebildet. In Strömungsrichtung eines Arbeitsmediums gesehen folgt im Heißgaskanal einer Leitschaufelreihe 117 eine aus Laufschaufeln 115 gebildete Reihe. Die Leitschaufeln 117 sind dabei an einem Innengehäuse eines Stators befestigt, wohingegen die Laufschaufeln 115 einer Reihe beispielsweise mittels einer Turbinenscheibe am Rotor angebracht sind. An dem Rotor angekoppelt ist ein Generator oder eine Arbeitsmaschine.

Während des Betriebes der Gasturbine wird vom Verdichter 101 durch das Ansauggehäuse 109 Luft angesaugt und verdichtet. Die am turbinenseitigen Ende des Verdichters 101 bereitgestellte verdichtete Luft wird zu den Brenneranordnungen 150 geführt und dort mit einem Brennstoff vermischt. Das Gemisch wird dann unter Bildung des Arbeitsmediums in der Brennkammer verbrannt. Von dort aus strömt das Arbeitsmedium entlang des Heißgaskanals an den Leitschaufeln 117 und den Laufschaufeln 115 vorbei. An den Laufschaufeln 115 entspannt sich das Arbeitsmedium impulsübertragend, so dass die Laufschaufeln 115 den Rotor antreiben und dieser die an ihn angekoppelte Arbeitsmaschine.

## Patentansprüche

1. Verfahren zur Beschichtung einer Oberfläche (23) einer potentiell brennstoffführenden Komponente (3, 20) eines Turbinenbauteils,
worin die Oberfläche (23) mittels chemischer Gasphasenabscheidung zunächst mit einer Titannitrid-Schicht (21) und anschließend mit einer α-Aluminiumoxid-Schicht (22) beschichtet wird.

2. Verfahren nach Anspruch 1,
worin eine Oberfläche (23), welche Stahl der Sorte 16Mo3 umfasst, beschichtet wird.

3. Verfahren nach Anspruch 1 oder 2,
worin die zu beschichtende Oberfläche (23) zunächst erhitzt wird, die erhitzte Oberfläche (23) mit Titannitrid und unmittelbar anschließend mit α-Aluminiumoxid beschichtet wird und die beschichtete Oberfläche dann wieder abgekühlt wird.

4. Verfahren nach einem der Ansprüche 1 bis 3,
worin die Beschichtung mit Titannitrid und α-Aluminiumoxid in demselben Ofen (1) durchgeführt wird.

5. Verfahren nach einem der Ansprüche 1 bis 4,
worin die Oberfläche (23) durch Gasphasenammonolyse oder Wasserstoff-Plasmabeschichtung mit Titannitrid beschichtet wird.

6. Verfahren nach einem der Ansprüche 1 bis 5,
worin die Oberfläche (23) im Rahmen der chemischen Gasphasenabscheidung mit einem Temperaturanstieg von zwischen 700°C/h und 900°C/h erhitzt wird.

7. Verfahren nach einem der Ansprüche 1 bis 6,
worin die Oberfläche (23) im Rahmen der chemischen Gasphasenabscheidung bei einem Druck zwischen 50mbar und 150mbar erhitzt und/oder abgekühlt wird.

8. Verfahren nach einem der Ansprüche 1 bis 7,
worin die Oberfläche (23) während des Erhitzens und/oder Abkühlens im Rahmen der chemischen Gasphasenabscheidung mit einem Argon und Wasserstoff umfassenden Gas gespült wird.

9. Verfahren nach einem der Ansprüche 1 bis 8,
worin die Oberfläche (23) im Rahmen der chemischen Gasphasenabscheidung mit einem Temperaturabfall von zwischen 300°C/h und 500°C/h abgekühlt wird.

10. Verfahren nach einem der Ansprüche 1 bis 9,
worin die Oberfläche (23) im Rahmen der chemischen Gasphasenabscheidung bei einer Temperatur zwischen 900°C und 1100°C beschichtet wird.

11. Verfahren nach einem der Ansprüche 1 bis 10,
worin die Oberfläche (23) im Rahmen der chemischen Gasphasenabscheidung bei einem Gasfluss von 16 l/h bis 20 l/h beschichtet wird.

12. Verfahren nach einem der Ansprüche 1 bis 11,
worin die Oberfläche (23) im Rahmen der chemischen Gasphasenabscheidung bei einem Druck zwischen 20mbar und 40mbar mit Titannitrid beschichtet wird und/oder bei einem Druck zwischen 80mbar und 120mbar mit α-Aluminiumoxid beschichtet wird.

13. Verfahren nach einem der Ansprüche 1 bis 12,
worin die Oberfläche (23) im Rahmen der chemischen Gasphasenabscheidung während einer Zeitdauer zwischen 2h und 4h mit Titannitrid beschichtet wird und/oder während einer Zeitdauer zwischen 3h und 5h mit α-Aluminiumoxid beschichtet wird.

14. Turbinenbauteil (3, 20), welches einen Grundwerkstoff und eine potentiell brennstoffführende Oberfläche (23) umfasst,
**dadurch gekennzeichnet, dass**
die Oberfläche (23) eine Titannitrid umfassende Zwischenschicht (21) und eine α-Aluminiumoxid umfassende Deckschicht (22) aufweist.

15. Gasturbine, die ein Turbinenbauteil (3, 20) nach Anspruch 14 umfasst.
